# EUROPEAN PATENT APPLICATION

(11) **EP 1 619 552 A2**
(43) Date of publication of application: **25.01.2006**
(21) Application number: 04030140.0
(22) Date of filing: 20.12.2004
(51) Int. Cl.: G03F 1/16

(54) **Method of designing charged particle beam mask, charged particle beam mask and charged particle beam transfer method**

(30) Priority: 20.07.2004 JP 2004211194
(71) Applicant: Renesas Technology Corp., Tokyo 100-6334 (JP)
(72) Inventor: Yamamoto, Jiro, Tsukuba-shi Ibaraki 305-8569 (JP)
(74) Representative: HOFFMANN EITLE

(57) **Abstract**

A method of designing a charged particle beam mask, comprises locating a plurality of identical chip patterns on a charged particle beam mask in which a plurality of subfields that can be transferred at a time are provided vertically and horizontally. The chip patterns have an arrangement pitch that is an integer multiple of the subfield.

## Description

### CROSS-REFERNCE TO ERLATED APPLICATIONS

This Application is based upon and claims the benefit of priority from the prior Japanese Patent Application No. 2004-211194, filed on July 20, 2004; the entire contents of which are incorporated herein by reference.

### BACKGROUND OF THE INVENTION

The invention relates to a method of designing a charged particle beam mask, a charged particle beam mask, and a charged particlebeamtransfermethod, andmoreparticularly, toamethod of designing a charged particle beam mask that allows die-to-die comparison inspection in mask defect inspection for a plurality of identical chips incorporated onto one mask, a chargedparticle beam mask formed by this method, and a charged particle beam transfer method using this mask.

With increased integration of semiconductor devices, the charged particle beam exposure method has drawn attention as means for achieving the downscaling of patterns. The charged particle beam exposure method enables finer patterning by transferring a pattern with charged particle beam such as electron beam.

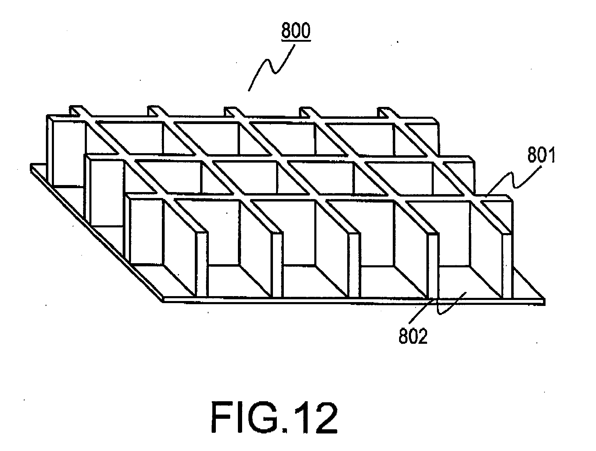

Fig. 12 is a schematic view showing a mask used for charged particle beam exposure.

As shown in Fig. 12, a charged particle beam mask 800 comprises a joist structure that is mechanically reinforced for maintaining mask strength. A pattern area partitioned by a supporting joist (strut) 801 is called "subfield". The subfield 802 corresponds to a (one-shot) area exposed at a time.

The subfield 802 has a size on the order of several hundreds of micrometers to several millimeters. Thus, in order to transfer a chip pattern of several centimeters, a plurality of patterns divided into subfields are connected.

In an electron beam transfer (Electron Projection Lithography) apparatus proposed by one apparatus manufacturer, the maximum chip size transferable with one mask is 20 mm x 25 mm. In a technique of incorporating and transferring the entire pattern into a mask like this, the entire area of the mask is scanned by electron beam regardless of whether it includes the pattern on the mask. Therefore, higher throughput is obtained by transferring patterns using as much area on the mask as possible. For this reason, when a plurality of chips can be arranged on one mask, multiple patterning is used.

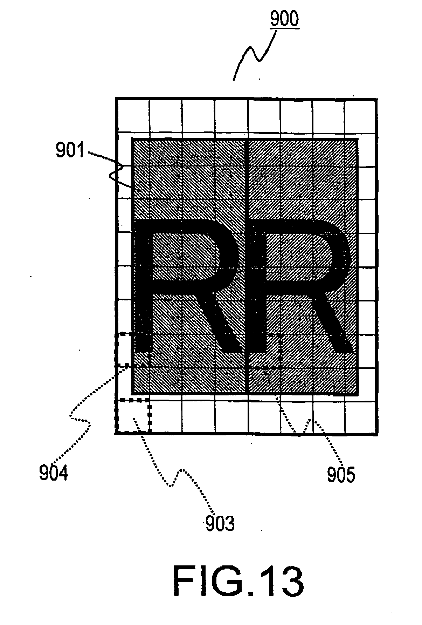

Fig. 13 is a schematic view showing an example chip layout of a mask subjected to multiple patterning.

In Fig. 13, two chips 901 and 902 are incorporated into one mask. The size of the maximum area transferable with one mask is 20 mm × 25 mm, which is divided into 8×10 subfields 903, each having a size of 2.5 mm × 2.5 mm.

Defect inspection methods for these charged particle beam masks are broadly classified into three approaches.

The first is cell-to-cell inspection in which repeating patterns in a chip is used for inspection. The second is die-to-database inspection, which compares a design data with the mask. The third is die-to-die inspection, which compares a plurality of chip patterns arranged on the same mask with each other (see, e.g., Japanese Laid-Open Patent Application 2002-244275).

Cell-to-cell inspection is effective when an identical cell is repeatedly arranged such as in DRAM (dynamic random access memory) , and high defect detection ratio can be expected. However, it cannot be used for non-repeated patterns.

Since die-to-database inspection makes comparison with the design data (database), inspection faithful to the design can be expected. However, the defect detection ratio depends on the accuracy of mask fabrication. For example, the defect detector may detect the so-called false defects including roundedness at a pattern corner and line width variation as mask defects. When the detection sensitivity is set lower so as not to detect false defects, there is concern about decreasing the defect detection accuracy.

Die-to-die inspection is performed by comparing a plurality of chips located in the same mask with each other on the assumption that any defect does not occur at an identical location of the chips. In this case, inspection is not affected by the accuracy of mask fabrication as in die-to-database inspection, and can be performed relatively easily.

In die-to-die inspection by a mask defect inspection apparatus, transmitted light from each of the identical patterns on the mask is imaged as an enlarged image on an image sensor such as CCD and converted into an electrical signal. The two electrical signals are compared, and any mismatched portions are detected.

When die-to-die inspection is performed on a charged particle beammask divided into subfields, the transmitted light is obtained for each subfield. Thus, difference in subfield division may prevent die-to-die inspection even for the identical chip patterns in the same mask. For example, in the charged particle beam shown in Fig. 13, the pattern formed in the subfield 904 is different from that formed in the subfield 905, which results in different transmitted light.

In addition, a charged particle beam mask may be subjected to the so-called complementary division in which one pattern is divided into two for ensuring mask strength and addressing donut patterns. In this case, pattern division for each subfield may result in different pattern division for the same mask. Therefore, a problem occurs that a plurality of chips on the mask have few locations with identical pattern shape, making die-to-die inspection impossible.

### SUMMARY OF THE INVENTION

According to an aspect of the invention, there is provided a method of designing a charged particle beam mask, comprising: locating a plurality of identical chip patterns on a charged particle beam mask in which a plurality of subfields that can be transferred at a time are provided vertically and horizontally, wherein the chip patterns have an arrangement pitch that is an integer multiple of the subfield.

The subfield may have a size of x vertically and *y* horizontally, and the arrangement pitch of the chip patterns may be mx vertically and ny horizontally, where m and n are integers.

The method may further comprise: generating a pattern location data by performing an operation of dividing one of the chip patterns into a plurality of the subfields; and generating a mask data by arranging the pattern location data at a pitch that is an integer multiple of the subfield.

The method may further comprise: storing, in a first data area, a pattern location data generated by performing an operation of dividing one of the chip patterns into a plurality of the subfields; storing, in a second data area, a data concerning a layout for arranging the pattern location data at a pitch that is an integer multiple of the subfield; and managing the first data area and the second data area in a hierarchical structure.

The method may further comprise: dividing the charged particle beammask into a plurality of mask areas, each of which is composed of a plurality of the subfields and can accommodate the chip pattern; and storing, in the second data area, a data concerning the number and arrangement of the mask areas.

According to other aspect of the invention, there is provided a method of designing a charged particle beam mask, comprising: locating a plurality of identical chip patterns on a charged particle beammask in which a plurality of subfields that can be transferred at a time are provided vertically and horizontally, wherein chip pattern groups each composed of a plurality of the chip patterns have an arrangement pitch that is an integer multiple of the subfield.

The subfield may have a size of x vertically and y horizontally, and the arrangement pitch of the chip pattern groups may be mx vertically and ny horizontally, where m and n are integers.

The method may further comprise: generating a pattern location data by performing an operation of dividing one of the chip patterns into a plurality of the subfields; and generating a mask data by arranging the pattern location data at a pitch that is an integer multiple of the subfield.

The method may further comprise: storing, in a first data area, a pattern group location data generated by performing an operation of dividing one of the chip pattern groups into a plurality of the subfields; storing, in a second data area, a data concerning a layout for arranging the pattern group location data at a pitch that is an integer multiple of the subfield; and managing the first data area and the second data area in a hierarchical structure.

The method may further comprise: dividing the charged particle beam mask into a plurality of mask areas, each of which is composed of a plurality of the subfields and can accommodate the chip pattern group; and storing, in the second data area, a data concerning the number and arrangement of the mask areas.

According to other aspect of the invention, there is provided a charged particle beam mask in which a plurality of subfields that can be transferred at a time are provided vertically and horizontally, comprising: a plurality of identical chip patterns arranged at a pitch that is an integer multiple of the subfield.

According to other aspect of the invention, there is provided a charged particle beam mask in which a plurality of subfields that can be transferred at a time are provided vertically and horizontally, each subfield having a size of x vertically and y horizontally, comprising: a first mask area having vertically *m* and horizontally n of the subfields; and a second mask area having vertically *m* and horizontally n of the subfields, wherein an identical chip pattern is allocated to the first mask area and the second mask area, and an identical pattern is allocated to the subfields located at the same position in the first and second mask areas.

The arrangement pitch of the chip patterns may be *mx* vertically and ny horizontally.

According to other aspect of the invention, there is provided a charged particle beam mask in which a plurality of subfields that can be transferred at a time are provided vertically and horizontally, comprising: a plurality of identical chip pattern groups arranged at a pitch that is an integer multiple of the subfield, each chip pattern group composed of a plurality of identical chip patterns.

According to other aspect of the invention, there is provided a charged particle beam mask in which a plurality of subfields that can be transferred at a time are provided vertically and horizontally, each subfield having a size of *x* vertically and *y* horizontally, comprising: a first mask area having vertically m and horizontally n of the subfields; and a second mask area having vertically m and horizontally n of the subfields, wherein an identical chip pattern group composed of a plurality of chip patterns is allocated to the first mask area and the secondmask area, and an identical pattern is allocated to the subfields located at the same position in the first and second mask areas.

The arrangement pitch of the chip pattern groups may be mx vertically and ny horizontally.

According to other aspect of the invention, there is provided a charged particle beam transfer method that uses a charged particle beam mask in which a plurality of subfields that can be transferred at a time are provided vertically and horizontally, and in which a plurality of identical chippatterns are arranged at a pitch that is an integer multiple of the subfield, comprising: a first transfer step of transferring a pattern formed by one of the plurality of identical chip patterns to a first wafer area on a wafer; and a second transfer step of transferring a pattern formed by a chip pattern adjacent to said one of the plurality of identical chip patterns to a second wafer area on the wafer, wherein after the first transfer step, charged particle beam is applied so that the first wafer area is adjacent to the second wafer area.

The charged particle beam mask may comprise a first mask area having vertically m and horizontally n of the subfields, and a second mask area having vertically m and horizontally n of the subfields, and an identical chip pattern may be allocated to the first mask area and the second mask area, and an identical pattern is allocated to the subfields located at the same position in the first and second mask areas.

According to other aspect of the invention, there is provided a charged particle beam transfer method that uses a charged particle beam mask in which a plurality of subfields that can be transferred at a time are provided vertically and horizontally, and in which a plurality of chip pattern groups each composed of a plurality of identical chip patterns are arranged at a pitch that is an integer multiple of the subfield, comprising: a first transfer step of transferring a pattern formed by one of the plurality of chip pattern groups to a first wafer area on a wafer; and a second transfer step of transferring a pattern formed by a chip pattern group adjacent to said one of the plurality of chip pattern groups to a second wafer area on the wafer, wherein after the first transfer step, charged particle beam is applied so that the first wafer area is adjacent to the second wafer area.

The charged particle beam mask may comprise a first mask area having vertically m and horizontally *n* of the subfields, and a second mask area having vertically m and horizontally n of the subfields, and an identical chip pattern group may be allocated to the first mask area and the second mask area, and an identical pattern is allocated to the subfields located at the same position in the first and second mask areas.

### BRIEF DESCRIPTION OF THE DRAWINGS

The present invention will be understood more fully from the detailed description given herebelow and from the accompanying drawings of the embodiments of the invention. However, the drawings are not intended to imply limitation of the invention to a specific embodiment, but are for explanation and understanding only.

In the drawings:
Fig. 1 is a flowchart showing a relevant part of a method of designing a charged particle beam mask according to a first embodiment of the invention;
Fig. 2 is a schematic view showing a layout of a charged particle beam mask according to the first embodiment of the invention;
Figs. 3A and 3B are schematic diagrams showing the data structure of design data for a charged particle beam mask according to the embodiment of the invention;
Fig. 4 is a schematic view of an exposure apparatus using a charged particle beam mask;
Figs. 5A and 5B are schematic views showing scanning exposure using a charged particle beam mask according to the embodiment of the invention;
Fig. 6 is a schematic view showing a layout (2×2) of a charged particle beam mask according to the embodiment of the invention;
Fig. 7 is a schematic view showing a layout (4×3) of a charged particle beam mask according to the embodiment of the invention;
Fig. 8 is a flowchart showing a relevant part of a method of designing a charged particle beam mask according to a second embodiment of the invention;
Fig. 9 is a schematic view showing a layout of a charged particle beam mask according to the second embodiment of the invention;
Fig. 10 is a schematic view showing a layout of a charged particle beam mask according to another specific example of the second embodiment of the invention;
Fig. 11 is a schematic view illustrating a chip pattern formed on a mask;
Fig. 12 is a schematic view showing a mask used for charged particle beam exposure; and
Fig. 13 is a schematic view showing an example chip layout of a mask subjected to multiple patterning.

### DETAILED DESCRIPTION

Embodiments of the invention will now be described with reference to the drawings.

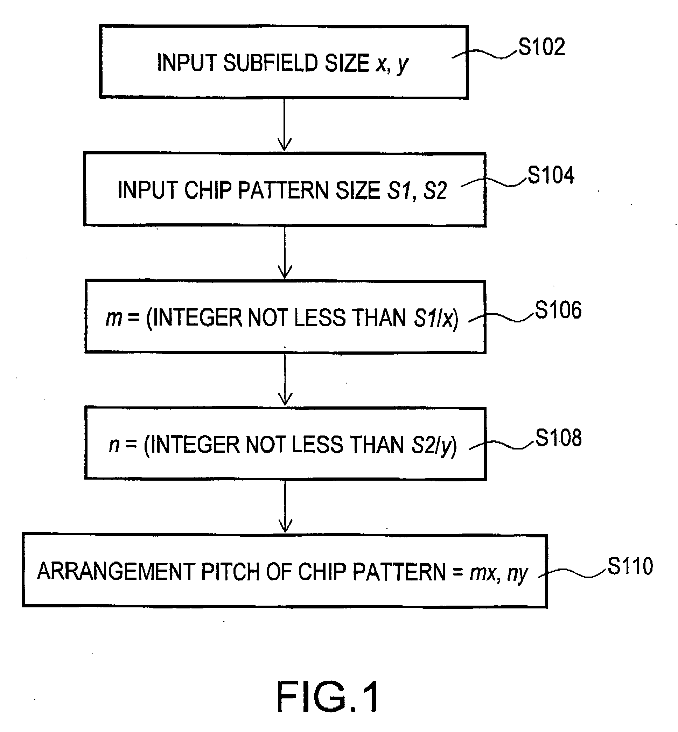

Fig. 1 is a flowchart showing a relevant part of a method of designing a charged particle beam mask according to a first embodiment of the invention.

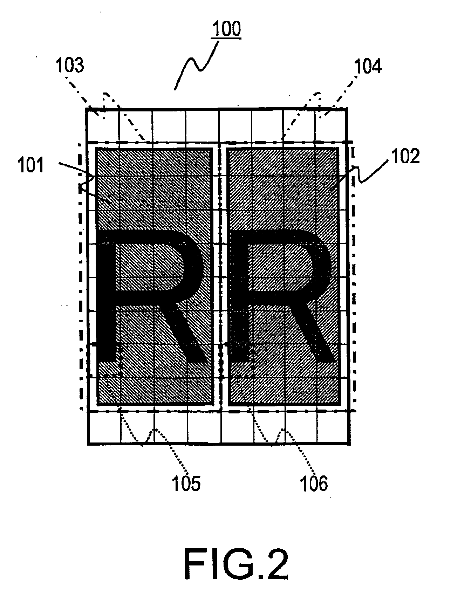

Fig. 2 is a schematic view showing a layout of a charged particle beam mask according to this embodiment.

The charged particle beam mask 100 illustrated in Fig. 2 has a transferable maximum area of 20 mm × 25 mm, which is composed of 8×10 subfields, each having a size of 2.5 mm × 2.5 mm. An example of forming chip patterns with a size of 8 mm × 18 mm will be described. It should be noted that a mask for practical use is provided with as many as 8000 subfields, for example. However, it is simplified here for ease of understanding.

In this embodiment, first, as shown in the flowchart of Fig. 1, the size *x*, *y* of subfield is inputted (step S102). The size of subfield of a charged particle beam mask is often determined as appropriate depending on the charged particle beam lithography apparatus being used. In the specific example shown in Fig. 2, *x* = 2.5 mm and *y* = 2.5 mm.

Next, chip pattern size *S1, S2* is inputted (step S104). The chip pattern size is uniquely determined by the size of a chip actuallymanufactured and the projection reduction ratio in the charged particle beam exposure process. In the specific example shown in Fig. 2, *S1* = 8 mm and *S2* = 18 mm. It should be noted that step S102 may be preceded by step S104.

Next, a parameter *m* is determined as (an integer not less than *S1*/*x*) (step S106). For example, in the specific example shown in Fig. 2, since (*S1*/*x*) = (8/2.5) = 3.2, the parameter m is determined as an integer of four ormore. When the parameter m is determined as the integer closest to (*S1*/*x*), the greatest number of chips can be accommodated in one mask. In the specific example shown in Fig. 2, the parameter m is selected to be four.

Next, a parameter n is determined as (an integer not less than *S2*/*y*) (step S108). For example, in the specific example shown in Fig. 2, since (*S2*/*y*) *=* (18/2.5) = 7.2, the parameter n is determined as an integer of eight or more. Again, when the parameter n is determined as the integer closest to (*S2*/*y*), the greatest number of chips can be accommodated in one mask. In the specific example shown in Fig. 2, the parameter n is selected to be eight.

Subsequently, the arrangement pitch of the chip patterns in the charged particle mask is set to *mx, ny*, and the chip patterns are arranged on the mask (step S110).

In the specific example shown in Fig. 2, it can be seen that one chip pattern is fit in 4×8 subfields. Thus, two chip patterns 101 and 102 can be formed in the mask 100. In this way, 2×1 mask areas 103 and 104, each composed of 4×8 subfields, are allocated to the mask 100.

Since the chip pattern 101 and the chip pattern 102 have an identical pattern, it is sufficient to design only one pattern and copy it to each mask area. The corresponding subfields 105 and 106 on the charged particle beam mask 100 thus obtained have an identical pattern, and they are also completely identical in complementary division. The chip patterns 101 and 102 are located at a pitch of four times the subfield size, and all the spacings between the corresponding patterns are the same.

According to this embodiment, when the charged particle beam mask 100 is subjected to mask defect inspection, die-to-die inspection can be performed by comparing the subfields 105 and 106 with each other. Similarly, die-to-die inspection can be applied to all the corresponding subfields.

When the charged particle beam mask 100 is designed, the chip pattern 101 is taken as original. It is sufficient that only the original chip pattern 101 is subjected to subfield division and complementary division of pattern, which is then arranged in duplicate.

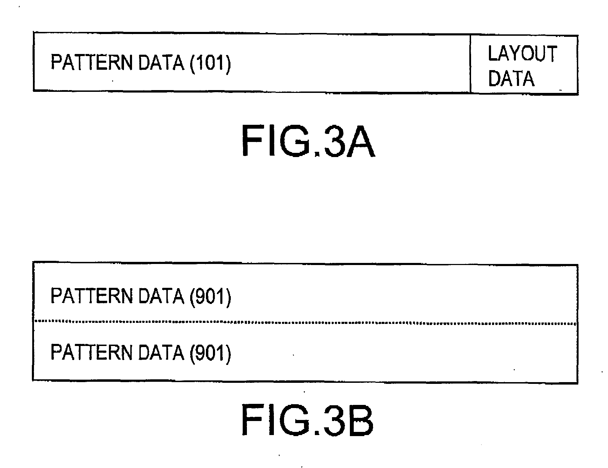

Figs. 3A and 3B are schematic diagrams showing the data structure of design data for a charged particle beam mask according to the embodiment of the invention. Fig. 3A shows a mask data according to the embodiment of the invention shown in Fig. 1. Fig. 3B shows a mask data of the mask shown in Fig. 13.

As shown in Fig. 3A, the mask design data is treated as a hierarchical structure of the original chip pattern 101 shown in Fig. 1 and the chip arrangement for locating 2x1 pieces of the pattern. The pattern data layer stores pattern data, and the layout information layer stores data for division and location of mask areas. The pattern data also includes pattern data subjected to complementary division.

On the other hand, in the data structure shown in Fig. 3B, the pattern layer stores pattern data corresponding to two patterns, that is, chip patterns 901 and 902 shown in Fig. 13. As described above, the chip pattern 901 and the chip pattern 902 have different pattern data because of their different subfield division. Thus, conventionally, the amount of information was nearly twice as great as that for Fig. 3A.

In this way, data volume can be reduced by managing mask design data with hierarchical structure. In addition, reduced data volume also reduces data processing time.

Next, a pattern transfer method using a charged particle beam mask according to the embodiment of the invention will be described.

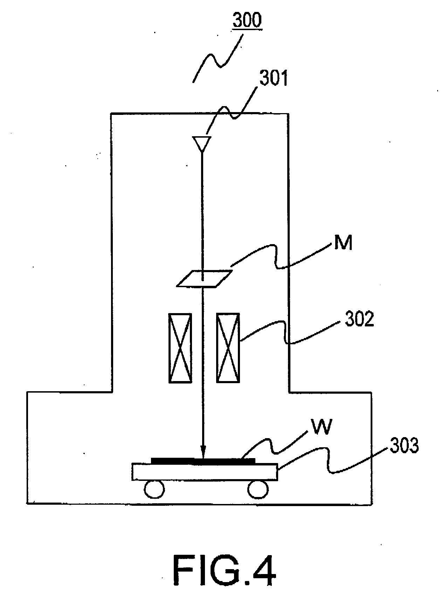

Fig. 4 is a schematic view of an exposure apparatus using a charged particle beammask, in which only the elements required for description are shown. The charged particle beam exposure apparatus 300 comprises a charged particle source 301, a mask M, a deflector 302 for adjusting the imaging of exposure light transmitted through the mask M, and a stage 303 on which a wafer W coated with resist is placed.

In performing pattern transfer, the mask M and the wafer W are subjected to relative synchronization processing by a mask stage driver and a wafer stage driver (not shown), respectively, and perform scanning exposure.

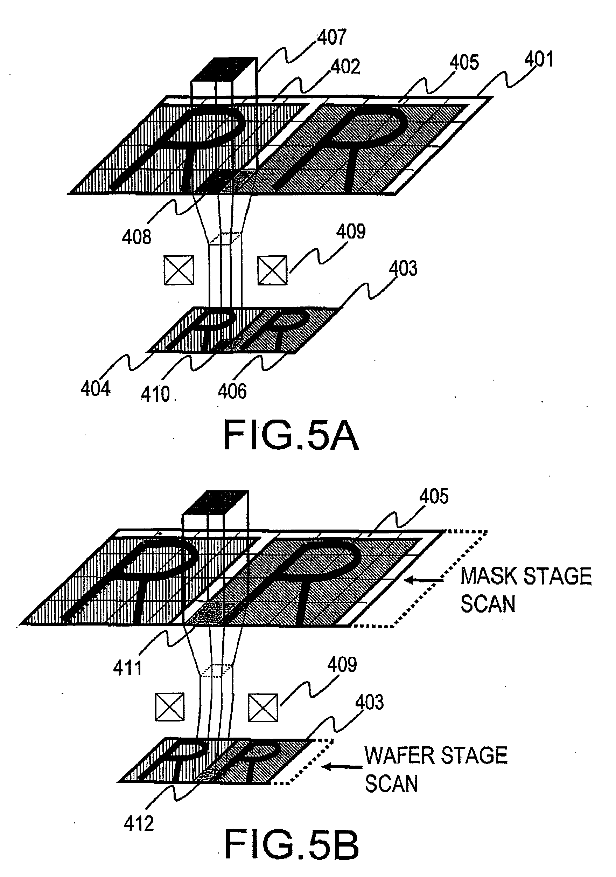

Figs. 5A and 5B are schematic views showing scanning exposure using a charged particle beam mask according to the embodiment of the invention.

A chip pattern 402 on a mask 401 is transferred to a wafer area 404 on a wafer 403. A chip pattern 405 is transferred to a wafer area 406 on the wafer 403.

The reduction ratio for transfer is four. Since there are also joists called "struts" on the mask, the actual chip size on the mask is four or more times the chip size formed on the wafer. Various dimensions adopted in the description are expressed by dimensions after transfer.

As shown in Fig. 5A, a subfield 408 on the mask 401 is exposed to charged particle beam 407 shaped into a size of subfield. The charged particle beam transmitted through the mask is reduced by a reducing lens (not shown) into its quarter size, deflected by deflector 409, and imaged onto a predetermined area 410 on the wafer 403. Fig. 5A just shows how the subfield 408 at the lower-right corner of the chip pattern 402 is transferred.

Since a device is fabricated by stacking a number of layers on the wafer, the chip spacings must be matched among various layers. Furthermore, the chip patterns 402, 405 also include scribe lines delineated along their boundary for dicing (cutting into chips) the completed wafer. For this reason, the chips on the wafer 403 are formed contiguously.

Fig. 5B shows, subsequent to the transfer in Fig. 5A, how the right adjacent subfield 411 is transferred. After the subfield 408 is transferred, the mask 401 and the wafer 403 are moved in the direction indicated by an arrow in the figure. By the so-called mask stage scan, the subfield 411 is set at the exposure area for the charged particle beam 407. At the same time, the wafer 403 is also set at a predetermined position by the mask stage scan. The pattern at the lower-left corner of the chip pattern 405 is formed in the subfield 411. The charged particle beam transmitted through the subfield 411 is reduced, deflected, and imaged onto a predetermined area 412 on the wafer 403. At this time, deflection by the deflector 409 includes, in addition to the amount of normal deflection, an offset caused by the spacing between chip patterns of the mask. Chips on the wafer 403 can be formed contiguously by providing the charged particle beam exposure apparatus with a function of adjusting this offset and the amount of deflection in response to the offset.

The foregoing describes an example of the charged particle beam mask having 2x1 mask areas. However, the arrangement of mask areas is arbitrary in both the vertical and horizontal directions. It may be determined in view of the mask size, subfield size, and chip size.

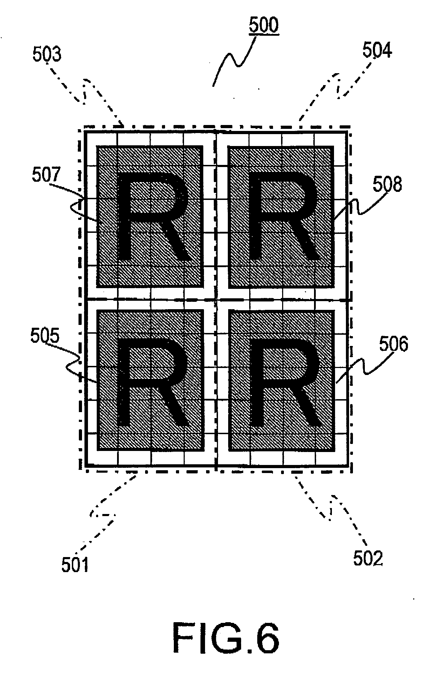

Fig. 6 is a schematic view showing a layout of a charged particle beam mask in which 2x2 chip patterns with a chip size of 8 mm x 12 mm are formed.

Assuming that the mask size and subfield size are the same as in Fig. 1, 2x2 mask areas 501, ..., 504, each composed of 4×5 subfields, are allocated to the mask 500. An identical chip pattern 505, ..., 508 is formed for each mask area.

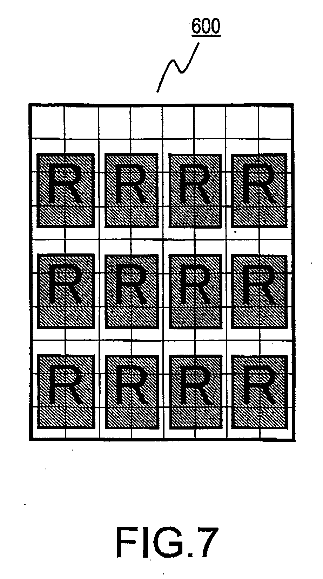

Fig. 7 is a schematic view showing a layout of a charged particle beam mask in which 4x3 chip patterns with a chip size of 4 mm × 5.6 mm are formed.

Assuming that the mask size and subfield size are the same as in Fig. 1, 4×3 mask areas, each composed of 2×3 subfields, are allocated to the mask 600. An identical chip pattern is formed for each mask area.

These charged particle beam masks allow die-to-die inspection in the mask defect inspection apparatus as with the charged particle beam mask shown in Fig. 1.

For the chips shown in Fig. 7, the maximum number of chips that can be formed in one mask is 5×4=20 chips. However, in the mask design according to the embodiment of the invention, the number of chips that can be formed in one mask is decreased to 4x3=12 chips. In this way, as the chip size decreases and the number of multiple patterning increases, the number of chips that can be formed in one mask decreases, which results in decreased throughput. Another method of designing a charged particle beam mask further improved on this point will now be described.

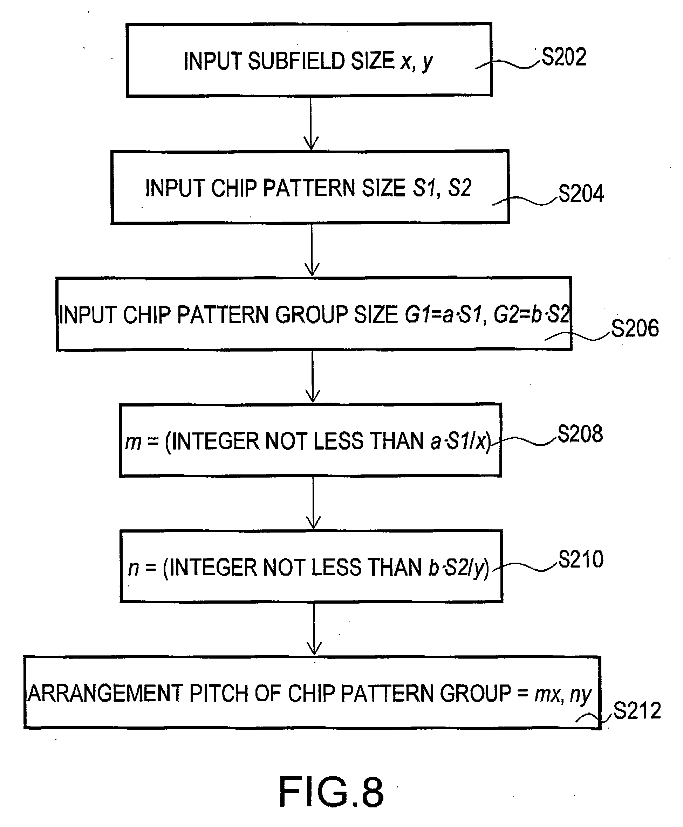

Fig. 8 is a flowchart showing a relevant part of a method of designing a charged particle beam mask according to a second embodiment of the invention.

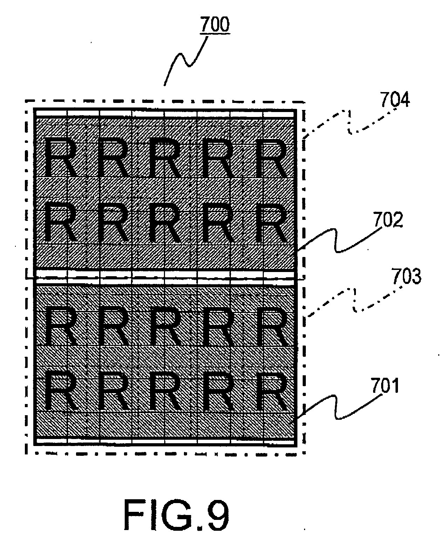

Fig. 9 is a schematic view showing a layout of a charged particle beam mask according to this embodiment.

In this embodiment, a plurality of chip patterns are grouped into a chip pattern group and treated in the same manner as one chip pattern shown in Fig. 1. Thus the number of chips formed in one mask is increased. Fig. 9 shows a specific example in which chip patterns with an identical size are formed on a charged particle beam mask having the same mask size and subfield size as in Fig. 7.

As shown in Fig. 9, the charged particle beam mask 700 has a transferable maximum area of 20 mm × 25 mm, which is composed of 8×10 subfields, each having a size of 2.5 mm x 2.5 mm. An example of forming 5x2 chip patterns with a chip size of 4 mm x 5.6 mm grouped into a chip pattern group will be described below.

In this embodiment again, first, as shown in the flowchart of Fig. 8, the size *x, y* of subfield is inputted (step S202). In the specific example shown in Fig. 9, x = 2.5 mm and *y* = 2.5 mm.

Next, chip pattern size *S1, S2* is inputted (step S204). In the specific example shown in Fig. 9, *S1* = 4 mm and *S2* = 5.6 mm. It should be noted also in this embodiment that step S202 may be preceded by step S204.

Next, the size *G1, G2* of chip pattern group is determined (step S206). For example, in the specific example shown in Fig. 9, chip patterns are contiguously arranged, five in the horizontal direction (x-direction) by two in the vertical direction (y-direction), to form chip pattern groups 701 and 702. That is, in this case, a = 5 and b = 2.

The size of chip pattern group can be determined as appropriate so that chips may be efficiently located in a mask with a given size.

Next, a parameter m is determined as (an integer not less than *a×S1*/*x*) (step S208). For example, in the specific example shown in Fig. 9, since (*a×S1*/*x*) *=* (5×4/2.5) = 8, the parameter m is determined as an integer of eight or more. When the parameter m is determined as the integer closest to (*a×S1*/*x*), the greatest number of chips can be accommodated in one mask. In the specific example shown in Fig. 9, the parameter m is selected to be eight.

Next, a parameter n is determined as (an integer not less than *b×S2*/*y*) (step S210). For example, in the specific example shown in Fig. 9, since (*b×S2*/*y*) *=* (2×5.6/2.5) = 4.48, the parameter n is determined as an integer of five or more. Again, when the parameter n is determined as the integer closest to (*b×S2*/*y*), the greatest number of chips can be accommodated in one mask. In the specific example shown in Fig. 9, the parameter n is selected to be five.

Subsequently, the arrangement pitch of the chip patterns in the charged particle mask is set to mx, ny, and the chip pattern groups are arranged on the mask (step S212).

It can be seen from Fig. 9 that one chip pattern group is fit in 8×5 subfields. Thus, two chip pattern groups 701 and 702 can be formed in the mask 700. In this way, 1×2 mask areas 703 and 704, each composed of 8×5 subfields, are allocated to the mask 700.

Since the chip pattern group 701 and the chip pattern group 702 have an identical pattern, it is sufficient to design only one pattern and copy it to each mask area. The corresponding subfields on the charged particle beam mask 700 thus obtained have an identical pattern, and they are also completely identical in complementary division. The chip pattern groups 701 and 702 are located at a pitch of five times the subfield size, and all the spacings between the corresponding patterns are the same. For this reason, when the charged particle beam mask 700 is subjected to mask defect inspection, die-to-die inspection can be applied to all the corresponding subfields.

When the charged particle beam mask 700 is designed, in a manner similar to the first embodiment as described above, the chip pattern group 701 is taken as original. It is sufficient that only the original chip pattern group 701 is subjected to subfield division and complementary division of pattern, which is then arranged in duplicate.

As with the first embodiment, the mask design data may also be managed as a hierarchical structure of the data for the original chip pattern and its associated layout information.

In respect of pattern transfer, the need for large deflection range is eliminated by treating a plurality of chip patterns as a chip pattern group. This is because the amount of deflection is adjusted for each chip group, rather than for each chip, when the transferred mask area is changed. This can also reduce the burden on the exposure apparatus.

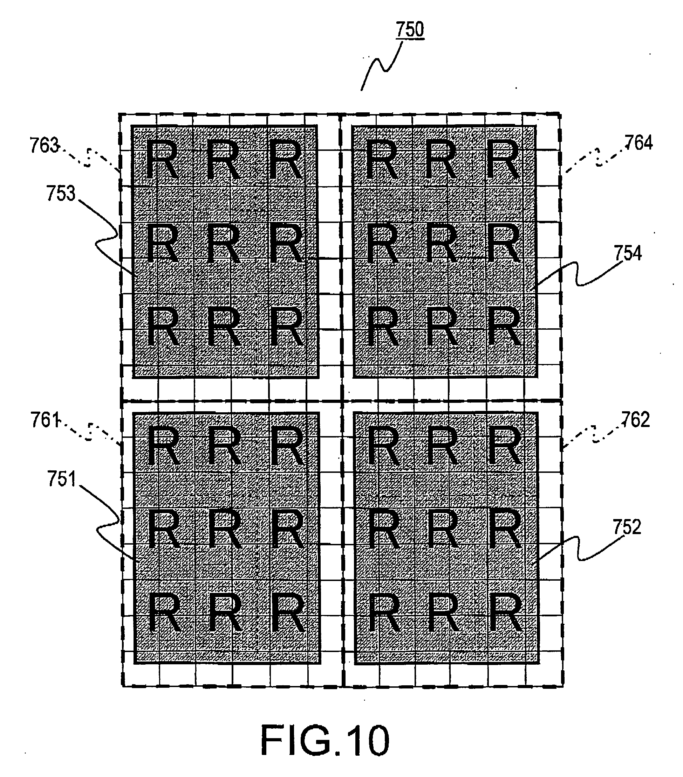

Fig. 10 is a schematic view showing another specific example of this embodiment.

More specifically, in this specific example, a mask 750 is composed of (12×16)=192 subfields. Four chip pattern groups 751, ..., 754, each having (3×3)=9 contiguously arranged chip patterns, are located on the mask at a fixed pitch. That is, the chip pattern groups 751, ..., 754 are allocated, respectively, to mask areas 761, ... , 764, each of which is composed of (6×8)=48 subfields. When the charged particle beammask 750 is subjected to mask defect inspection, die-to-die inspection can be applied to the corresponding subfields among the mask areas 761, ..., 764. It should be noted that determination by die-to-die inspection is facilitated by locating three or more chip pattern groups on the mask. That is, for only two chip pattern groups, when any corresponding subfields are different in die-to-die inspection, it is not easy to determine which of them is defective. In contrast, for three or more chip pattern groups, any chip pattern group belonging to the minority can be determined to be defective.

As described above, the method of designing a charged particle beam mask and its design data structure, the charged particle beam mask, and the transfer method using the same according to the invention allows die-to-die comparison inspection inmaskdefect inspection for a plurality of identical chips incorporated onto one mask and facilitates the mask inspection process. In addition, the volume of mask design data can be reduced, and data processing time is also reduced.

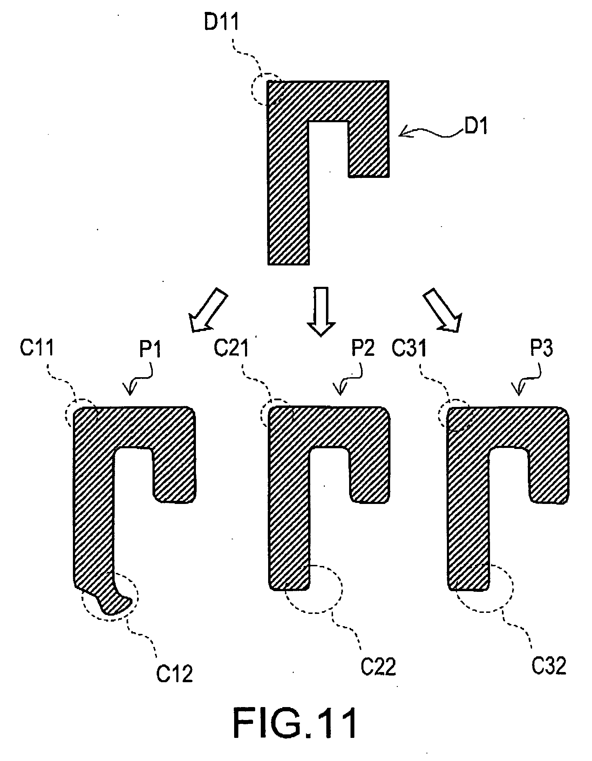

Fig. 11 is a schematic view illustrating a chip pattern formed on a mask.

More specifically, chip patterns P1, ..., P3 are formed on a stencil or membrane mask based on a chip pattern D1 on the database. At this time, the chip pattern D1 on the database has an exactly accurate shape and size. For example, in the crank-shaped pattern illustrated in Fig. 11, the linear portion is exactly linear, and the corner D11 is exactly square.

In contrast, the shape and size of the patterns P1, ..., P3 actually formed on the mask may vary depending on the beam size of the electron beam used, exposure condition of resist, or etching condition of maskmaterial. For example, the corners C11, C21, and C31 are often rounded. However, a certain amount of roundedness at a corner is within an allowance. In this case, when die-to-database inspection is performed, for example, such allowable roundedness at a corner is always detected as "defective", which significantly increases the lead time of the inspection process. On the other hand, when the detection sensitivity is set lower so as not to detect false defects, there is a problem of missing defects to be detected.

In contrast, according to this embodiment, die-to-die inspection can be performed reliably and easily by locating chip patterns or chip pattern groups at a pitch that is an integer multiple of a subfield. More specifically, in the specific example shown in Fig. 11, comparison is made among the chip patterns P1, ..., P3 formed on the mask. In this case, all the corners C11, C21, and C31 have comparable roundedness, which significantly reduces the possibility of being detected as defective.

On the other hand, the corner C12 of the chip pattern P1 can be reliably and easily detected as "defective" by comparison with the corresponding corners C22 and C32.

That is, according to this embodiment, die-to-die inspection can be performed reliably and easily, which allows mask inspection with accuracy in an extremely short time without decreasing the precision of mask inspection.

While the present invention has been disclosed in terms of the embodiment in order to facilitate better understanding thereof, it should be appreciated that the invention can be embodied in various ways without departing from the principle of the invention. Therefore, the invention should be understood to include all possible embodiments and modification to the shown embodiments which can be embodied without departing from the principle of the invention as set forth in the appended claims.

## Claims

1. A method of designing a charged particle beam mask, comprising:
locating a plurality of identical chip patterns on a charged particle beam mask in which a plurality of subfields that can be transferred at a time are provided vertically and horizontally, wherein
the chip patterns have an arrangement pitch that is an integer multiple of the subfield.

2. The method of designing a charged particle beam mask as claimed in claim 1, wherein
the subfield has a size of *x* vertically and *y* horizontally, and
the arrangement pitch of the chip patterns is *mx* vertically and ny horizontally, where *m* and *n* are integers.

3. The method of designing a charged particle beam mask as claimed in claim 1, further comprising:
generating a pattern location data by performing an operation of dividing one of the chip patterns into a plurality of the subfields; and
generating a mask data by arranging the pattern location data at a pitch that is an integer multiple of the subfield.

4. The method of designing a charged particle beam mask as claimed in claim 1, further comprising:
storing, in a first data area, a pattern location data generated by performing an operation of dividing one of the chip patterns into a plurality of the subfields;
storing, in a second data area, a data concerning a layout for arranging the pattern location data at a pitch that is an integer multiple of the subfield; and
managing the first data area and the second data area in a hierarchical structure.

5. The method of designing a charged particle beam mask as claimed in claim 4, further comprising:
dividing the charged particle beam mask into a plurality of mask areas, each of which is composed of a plurality of the subfields and can accommodate the chip pattern; and
storing, in the second data area, a data concerning the number and arrangement of the mask areas.

6. A method of designing a charged particle beam mask, comprising:
locating a plurality of identical chip patterns on a charged particle beam mask in which a plurality of subfields that can be transferred at a time are provided vertically and horizontally, wherein
chip pattern groups each composed of a plurality of the chip patterns have an arrangement pitch that is an integer multiple of the subfield.

7. The method of designing a charged particle beam mask as claimed in claim 6, wherein
the subfield has a size of *x* vertically and *y* horizontally, and
the arrangement pitch of the chip pattern groups is *mx* vertically and *ny* horizontally, where *m* and *n* are integers.

8. The method of designing a charged particle beam mask as claimed in claim 6, further comprising:
generating a pattern location data by performing an operation of dividing one of the chip patterns into a plurality of the subfields; and
generating a mask data by arranging the pattern location data at a pitch that is an integer multiple of the subfield.

9. The method of designing a charged particle beam mask as claimed in claim 6, further comprising:
storing, in a first data area, a pattern group location data generated by performing an operation of dividing one of the chip pattern groups into a plurality of the subfields;
storing, in a second data area, a data concerning a layout for arranging the pattern group location data at a pitch that is an integer multiple of the subfield; and
managing the first data area and the second data area in a hierarchical structure.

10. The method of designing a charged particle beam mask as claimed in claim 9, further comprising:
dividing the charged particle beam mask into a plurality of mask areas, each of which is composed of a plurality of the subfields and can accommodate the chip pattern group; and
storing, in the second data area, a data concerning the number and arrangement of the mask areas.

11. A charged particle beam mask in which a plurality of subfields that can be transferred at a time are provided vertically and horizontally, comprising:
a plurality of identical chip patterns arranged at a pitch that is an integer multiple of the subfield.

12. A charged particle beam mask in which a plurality of subfields that can be transferred at a time are provided vertically and horizontally, each subfield having a size of *x* vertically and *y* horizontally, comprising:
a first mask area having vertically *m* and horizontally *n* of the subfields; and
a second mask area having vertically *m* and horizontally *n* of the subfields, wherein
an identical chip pattern is allocated to the first mask area and the second mask area, and an identical pattern is allocated to the subfields located at the same position in the first and second mask areas.

13. The charged particle beam mask as claimed in claim 12, wherein the arrangement pitch of the chip patterns is *mx* vertically and *ny* horizontally.

14. A charged particle beam mask in which a plurality of subfields that can be transferred at a time are provided vertically and horizontally, comprising:
a plurality of identical chip pattern groups arranged at a pitch that is an integer multiple of the subfield, each chip pattern group composed of a plurality of identical chip patterns.

15. A charged particle beam mask in which a plurality of subfields that can be transferred at a time are provided vertically and horizontally, each subfield having a size of *x* vertically and *y* horizontally, comprising:
a first mask area having vertically *m* and horizontally *n* of the subfields; and
a second mask area having vertically *m* and horizontally *n* of the subfields, wherein
an identical chip pattern group composed of a plurality of chip patterns is allocated to the first mask area and the second mask area, and an identical pattern is allocated to the subfields located at the same position in the first and second mask areas.

16. The charged particle beam mask as claimed in claim 15, wherein the arrangement pitch of the chip pattern groups is *mx* vertically and *ny* horizontally.

17. A charged particle beam transfer method that uses a charged particle beam mask in which a plurality of subfields that can be transferred at a time are provided vertically and horizontally, and in which a plurality of identical chip patterns are arranged at a pitch that is an integer multiple of the subfield, comprising:
a first transfer step of transferring a pattern formed by one of the plurality of identical chip patterns to a first wafer area on a wafer; and
a second transfer step of transferring a pattern formed by a chip pattern adj acent to said one of the plurality of identical chip patterns to a second wafer area on the wafer, wherein
after the first transfer step, charged particle beam is applied so that the first wafer area is adjacent to the second wafer area.

18. The charged particle beam transfer method as claimed in claim 17, wherein
the charged particle beam mask comprises a first mask area having vertically m and horizontally *n* of the subfields, and a second mask area having vertically *m* and horizontally *n* of the subfields, and
an identical chip pattern is allocated to the first mask area and the second mask area, and an identical pattern is allocated to the subfields located at the same position in the first and second mask areas.

19. A charged particle beam transfer method that uses a charged particle beam mask in which a plurality of subfields that can be transferred at a time are provided vertically and horizontally, and in which a plurality of chip pattern groups each composed of a plurality of identical chip patterns are arranged at a pitch that is an integer multiple of the subfield, comprising:
a first transfer step of transferring a pattern formed by one of the plurality of chip pattern groups to a first wafer area on a wafer; and
a second transfer step of transferring a pattern formed by a chip pattern group adjacent to said one of the plurality of chip pattern groups to a second wafer area on the wafer, wherein
after the first transfer step, charged particle beam is applied so that the first wafer area is adjacent to the second wafer area.

20. The charged particle beam transfer method as claimed in claim 19, wherein
the charged particle beam mask comprises a first mask area having vertically *m* and horizontally *n* of the subfields, and a second mask area having vertically *m* and horizontally *n* of the subfields, and
an identical chip pattern group is allocated to the first mask area and the second mask area, and an identical pattern is allocated to the subfields located at the same position in the first and second mask areas.
